**Europäisches Patentamt**

**European Patent Office**

**Office européen des brevets**

(19)

(11) Veröffentlichungsnummer : **0 025 502**
**B1**

(12) **EUROPÄISCHE PATENTSCHRIFT**

(45) Veröffentlichungstag der Patentschrift :
08.02.84

(51) Int. Cl.³ : **H 03 K   3/288**, H 03 K   3/013

(21) Anmeldenummer : 80104533.7

(22) Anmeldetag : 31.07.80

(54) **Speicherkippschaltung mit Stromverteilungsschaltern.**

(30) Priorität : **17.09.79 US 75921**

(43) Veröffentlichungstag der Anmeldung :
**25.03.81 Patentblatt 81/12**

(45) Bekanntmachung des Hinweises auf die Patenterteilung : 08.02.84 Patentblatt 84/06

(84) Benannte Vertragsstaaten :
**DE FR GB**

(56) Entgegenhaltungen :
**US-A- 3 339 089**
**US-A- 3 505 535**
**US-A- 3 612 911**
**US-A- 3 649 852**
**US-A- 3 740 590**
**US-A- 3 984 702**

(73) Patentinhaber : **International Business Machines Corporation**
**Old Orchard Road**
**Armonk, N.Y. 10504 (US)**

(72) Erfinder : **Chang, Albert Yuan**
**Partners Trace**
**Poughkeepsie N.Y. 12630 (US)**
Erfinder : **Pandya, Punit Jayamukh**
**32 Carriage Hill Lane**
**Poughkeepsie N.Y. 12603 (US)**

(74) Vertreter : **Lewit, Leonard, Dipl.-Ing.**
**Schönaicher Strasse 220**
**D-7030 Böblingen (DE)**

## Speicherkippschaltung mit Stromverteilungsschaltern

Die Erfindung bezieht sich auf eine Speicherkippschaltung mit Stromverteilungsschaltern, die jeweils über einen Emitterfolger mit dem Ausgang der Kippschaltung verbunden sind.

Beim Wechsel des in der Kippschaltung zu speichernden binären Signales oder des zur Steuerung der Kippschaltung verwendeten Taktsignales entstehen am Ausgang der Kippschaltung zumeist Störsignalspitzen als Folge der Vorder- und Rückflanke der an der Kippschaltung anliegenden Impulse. Diese Störsignalspitzen sind hauptsächlich auf die asymmetrische Wirkungsweise der beiden ausgangsseitig miteinander verbundenen Emitterfolger zurückzuführen, da jeweils ein Emitterfolger eingeschaltet und der andere ausgeschalschaltet wird, wenn die zur Steuerung der Stromverteilungsschalter verwendeten Taktimpulse umschalten. Bei diesem Ein- und Ausschalten entsteht ein störendes Differenzsignal, welches sich als plötzliche Änderung des Ausgangssignales bemerkbar macht. Man könnte diese Störspitzen dadurch vermindern, daß der eine Emitterfolger erst voll eingeschaltet wird, bevor der andere abgeschaltet wird. Hierdurch wird jedoch die Arbeitsweise der Kippschaltung verzögert. Ohne Verringerung der Störspitzen besteht jedoch die Gefahr einer fehlerhaften Arbeitsweise der nachfolgenden Kippschaltungen.

Der Erfindung liegt die Aufgabe zugrunde, Störspannungsspitzen am Ausgang der Kippschaltung durch geeignete Ansteuerung der beiden Ausgangs-Emitterfolger zu verringern, ohne daß dabei die Arbeitsweise der Kippschaltung verzögert wird.

Die erfindungsgemäße Speicherkippschaltung zur Lösung dieser Aufgabe ist in den Ansprüchen gekennzeichnet.

Die Erfindung erreicht die Verringerung der Störspannungsspitzen also durch eine interne Kompensation. Die Abschaltung des einen Emitterfolgers verläuft hierdurch etwas langsamer, während das Anschalten des anderen Emitterfolgers beschleunigt wird. Insgesamt entsteht also hierdurch keine Verzögerung und das Ausgangssignal bleibt von der Änderung der anliegendenden Pulssignale ziemlich unbeeinflußt. Die interne Kompensation wird dadurch erreicht, daß ein teilweise gemeinsamer Kollektorwiderstand für die beiden Eingangstransistoren der beiden Stromverteilungsschalter vorgesehen wird. Wenn die Basiselektroden der beiden Emitterfolger jeweils direkt mit der Kollektorelektrode des betreffenden Eingangstransistors der Stromverteilungskippschaltung verbunden sind, liegen an den beiden Basiselektroden der Emitterfolger die gleichen Steuerspannungen, wenn jeweils der Kollektor des Eingangstransistors mit dem gemeinsamen Kollektorwiderstand, der auch Verschiebungswiderstand genannt werden kann, über einen Kollektorwiderstand von für beide Eingangstransistoren gleichem Wert verbunden ist. Da hierdurch also die Steuerspannungen zu den beiden Emitterfolgern gleich gehalten werden können, werden diese Emitterfolger auch von den Taktpulsen in gleicher Weise ein- bzw. ausgeschaltet, wodurch der eine Emitterfolger rasch eingeschaltet wird, während der andere Emitterfolger langsam ausgeschaltet wird. Als Folge hiervon bleibt das Ausgangssignal im wesentlichen konstant und wird ein Signalflackern am Ausgang der Kippschaltung vermieden.

Im folgenden wird die Erfindung anhand von lediglich einen Ausführungsweg darstellenden Figuren näher erläutert.

Es zeigt:

Figur 1 in einem Blockschema die logischen Elemente und Verbindungen einer Speicherkippschaltung,

Figur 2 ein Schaltschema einer Speicherkippschaltung mit Stromverteilungsschaltern mit am Ausgang zusammengeschalteten Emitterfolgern, in welchem Schaltschema zum Großteil bekannte Elemente gezeigt sind,

Figur 3 Datensignale und sowohl negative als auch positive Taktpulssignale sowie Ausgangssignale, mit Bezug auf Fig. 2,

Figur 4 ein Schaltschema der erfindungsgemäßen Speicherkippschaltung.

Figur 5 Daten- und Taktpulssignale, mit Bezug auf Fig. 4.

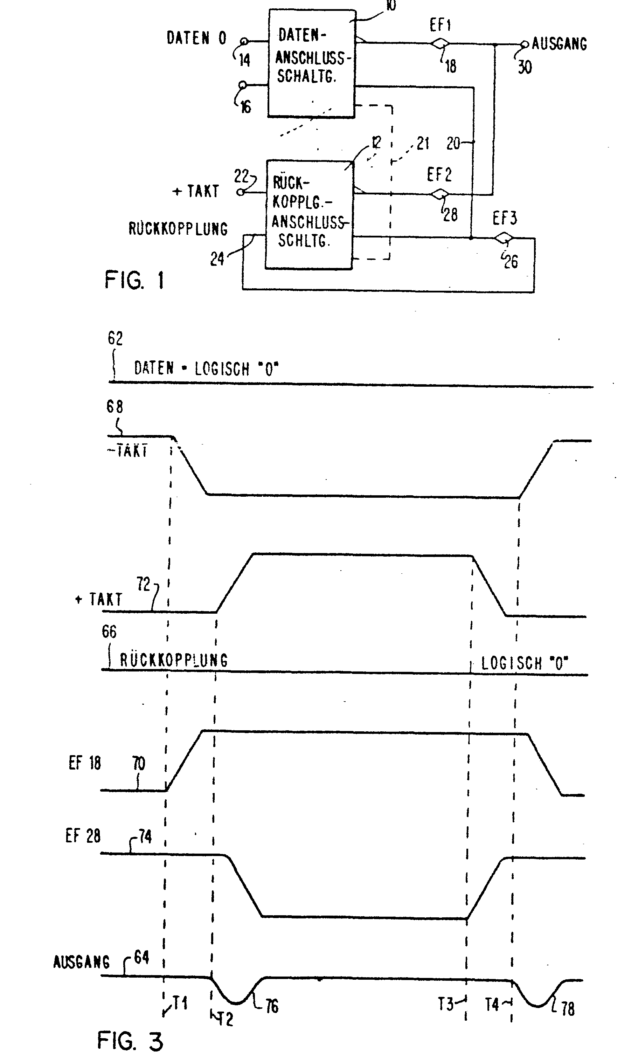

Fig. 1 zeigt eine Speicherkippschaltung mit einem ersten Stromverteilungsschalter 10 und einem zweiten Stromverteilungsschalter 12, welche in Fig. 1 als Datenanschlußschaltung, bzw. als Rückkoppelungs-Anschlußschaltung bezeichnet sind. An den Schalter 10 wird ein Datensignal 14 an einen ersten Eingang angelegt, das mit einem Signal hohen Potentials eine binäre 1 und mit einem Signal niederen Potentials (z. B. 0) eine binäre 0 anzeigt. An den Schalter 10 wird auch ein negatives Taktsignal 16 an einen zweiten Eingang angelegt. Das negative Taktsignal variiert zwischen einem positiven Potentialniveau und einem negativen Potentialniveau, wobei der aktive Teil des negativen Taktpulssignales im negativen Potentialniveau liegt. Ein Ausgangssignal des Schalters 10 kann von einem Emitterfolger 18 erhalten werden. Der Schalter 10 ist über eine Verbindung 20 mit dem Schalter 12 verbunden. Die Wirkungsweise dieser Verbindung 20 wird weiter unten beschrieben. In Fig. 1 ist außerdem eine gestrichelte Verbindung 21 zwischen den beiden Schaltern 10 und 12 gezeichnet, deren erfindungsgemäße Bedeutung ebenfalls weiter unten beschrieben wird.

Ein positives Taktsignal 22 wird an einen ersten Eingang des Schalters 12 angelegt. Das positive Taktsignal variiert zwischen einem negativen Potentialniveau und einem positiven Potentialniveau, wobei der aktive Teil dieses Taktsignales durch das positive Potentialniveau gegeben ist. Zum Schalter 12 ist ein zweiter Eingang vorgesehen, der mit einer Rückkopplungsschleife 24 verbunden ist, die mit der Verbindung 20 über einen Emitterfolger 26 verbunden ist. Ein Ausgangssignal vom Schalter 12 wird über einen Emitterfolger 28 erhalten, der ausgangsseitig mit dem Emitterfolger 18 verbunden ist. Die Ausgänge, d. h. die Emitter jeweils der beiden Emitterfolger sind also zusammen verbunden, wobei dieser Verbindungspunkt die Ausgangsklemme 30 der Kippschaltung darstellt.

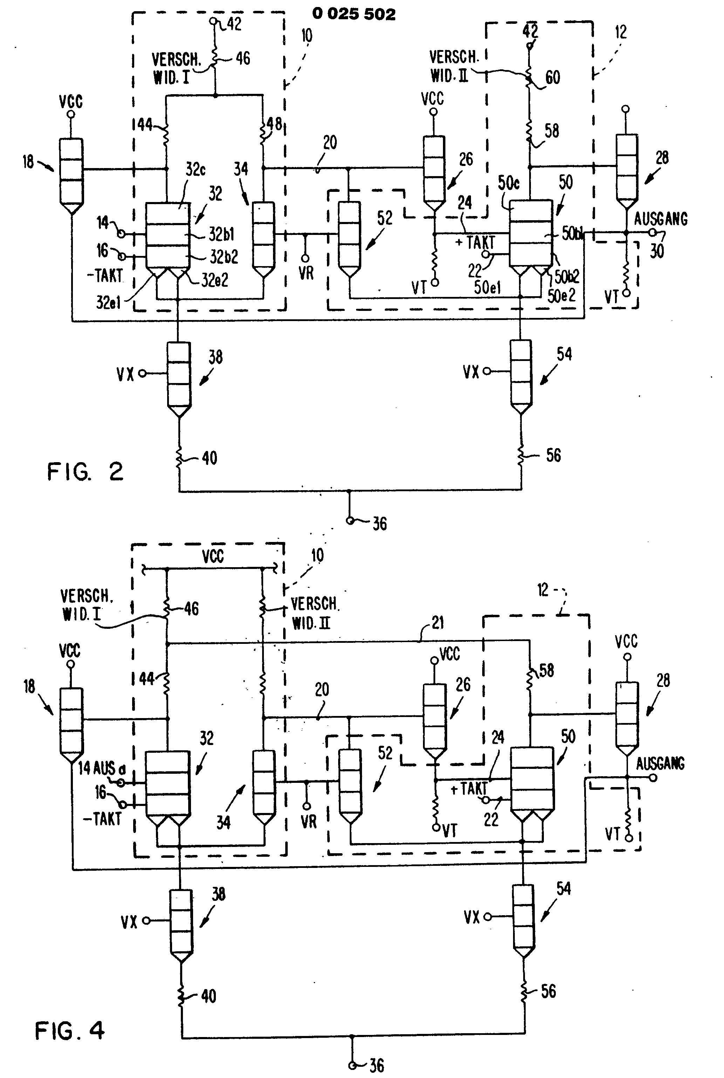

Die in Fig. 1 gezeigte Kippschaltung ist bis auf die Verbindung 21 in Fig. 2 näher erläutert. Die Schaltung nach Fig. 2 hat den Nachteil, daß ein Signalflackern am Ausgang erzeugt wird, wenn am Dateneingang 14 eine binäre 0 anliegt, wenn die Rückkopplungsverbindung 24 einen Nullzustand aufweist, und wenn sowohl das positive als auch das negative Taktsignal aktiv werden. Hierbei erfolgt nämlich das Anschalten des Emitterfolgers 18 und das Abschalten des Emitterfolgers 28 nicht nach dem gleichen, einander entgegengesetzten Verlauf, so daß Schwankungen des Ausgangssignales an der Klemme 30 merkbar werden. Für andere Zustände des Datensignales und der Rückkopplungsverbindung besteht dieses Problem nicht. Wenn sowohl der Dateneingang als auch die Rückkopplungsverbindung im « 1 »-Zustand sind, werden beide Emitterfolger auf gleiche Weise eingeschaltet. Wenn andererseits der Zustand jeweils des Dateneinganges und der Rückkopplungsverbindung verschieden ist, ändert sich das Ausgangspotential an der Klemme 30, so daß demgegenüber ein eventuelles Signalflackern an der Ausgangsklemme 30 nicht stört.

Der in Fig. 1 gezeigte Stromverteilungsschalter 10 weist gemäß Fig. 2 als Eingangstransistor einen Multiemittertransistor 32 mit den Emittern 32e1 und 32e2 sowie mit den Basisbereichen 32b1 und 32b2 auf. Am Kollektor 32c wird vom Transistor 32 ein invertiertes Ausgangssignal erzeugt. Im Stromverteilungsschalter 10 ist außerdem ein Einfachemittertransistor 34 vorgesehen, dessen Emitter mit den beiden Emittern des Multiemittertransistors 32 verbunden ist.

An die beiden Basisanschlüsse des Transistors 32 wird das Dateneingangssignal 14 und das negative Taktsignal 16 angelegt. Die Basiselektrode des Transistors 34 ist mit einer Referenzspannung VR verbunden. Der gemeinsame Verbindungspunkt der Emitter der beiden Transistoren ist mit einer Stromsenke 36 über einen von einem Signal VX gesteuerten Transistor 38 und einen Widerstand 40 verbunden. Der Kollektor 32c des Transistors 32 ist mit dem Anschluß 42 einer Speisespannung $V_{cc}$ über zwei in Serie geschaltete Kollektorwiderstände, nämlich einen Lastwiderstand 44 und einen Verschiebungswiderstand 46 verbunden. Der Verschiebungswiderstand 46 hat die Aufgabe eine Variation des Ausgangssignales festzulegen, welche symmetrisch zum Referenzpotential (z. B. Masse) liegt. Der Emitterfolger 18 wird vom Kollektorsignal des Transistors 32 gesteuert.

Der Kollektor des Transistors 34 ist mit dem Anschluß 42 der Speisespannung über einen Lastwiderstand 48 und den Verschiebungswiderstand 46 verbunden. Mit dem Kollektor des Transistors 34 ist die Basis eines Emitterfolgers 26 verbunden.

Auch der Stromverteilungsschalter 12 weist als Eingangstransistor einen Multiemittertransistor 50 mit den beiden Emittern 50e1 und 50e2 sowie mit den beiden Basisbereichen 50b1 und 50b2 auf. Ein invertiertes Ausgangssignal kann am Kollektor 50c des Transistors 50 erhalten werden. Im Schalter 12 ist ferner ein Einfachemittertransistor 52 vorgesehen, der ein nichtinvertiertes Ausgangssignal liefert.

Ferner ist ein Emitterfolger 28 vorgesehen, dessen Basis mit dem Kollektor 50c des Transistors 50 verbunden ist. Am Emitter, d. h. am Ausgang des Emitterfolgers 28 kann ein nichtinvertiertes Ausgangssignal erhalten werden. Die Emitter der beiden Transistoren 50 und 52 sind miteinander verbunden, wobei dieser Verbindungspunkt über einen vom Signal VX gesteuerten Transistor 54 und einen Widerstand 56 mit der Stromsenke 36 der Speisespannung verbunden ist. Der Transistor 52 erzeugt ein Rückkopplungssignal zum Transistor 50, welches vom Kollektor des Transistors 52 zu der Basis des Transistors 50 über einen Emitterfolger 26 und eine Rückkopplungsverbindung 24 geführt wird. Der Emitter des Transistors 26 ist über den Emitterlastwiderstand mit der Speisespannung VT verbunden. Die Kollektoren der beiden Transistoren 34 und 52 sind ebenfalls über die Verbindung 20 miteinander verbunden, und ebenfalls sind auch ihre beiden Basiselektroden miteinander und mit der Referenzspannung VR verbunden.

An die Basiselektroden des Transistors 50 werden das positive Taktsignal 22 und das Rückkopplungssignal über die Verbindung 24 angelegt. Der Kollektor des Transistors 50 ist mit dem Anschluß 42 der Speisespannung über einen Kollektorwiderstand 58 und einen zweiten Verschiebungswiderstand 60 verbunden. Die Emitterelektrode des Emitterfolgers 28 ist mit der Emitterelektrode des Transistors 18 verbunden. Ein Ausgangssignal wird an dieser gemeinsamen Verbindung der beiden Emitter der beiden Emitterfolger 18 und 28 an der Klemme 30 erhalten.

Das bereits angesprochene Signalflackern am Ausgang der in Fig. 2 gezeigten Schaltung soll nun unter Bezugnahme auf Fig. 3 näher erläutert werden. In Fig. 3 liegt sowohl das Datensignal 62, als auch das Rückkopplungssignal 66 auf niederem Potential, d. h. auf logisch « Null ». Zum Zeitpunkt $T_1$ wird am Ausgang 30 der Schaltung ein Ausgangssignal erzeugt, daß in Fig. 3 mit 64 bezeichnet ist und hohes Potential führt. Das Potential 66 der Rückkopplungsschleife liegt niedrig, da angenommen wird, daß auch das vorhergehende Datensignal eine binäre 0 war (niederes Potential).

Wenn ein negatives Taktsignal 68 an die Klemme 16 zum Zeitpunkt $T_1$ angelegt wird, wird

der Transistor 32 abgeschaltet und beginnt der Emitterfolger 18 leitender zu werden, wodurch ein Ausgangssignal 70 erzeugt wird. Dieses Ausgangssignal 70 steigt in dem Maße an, wie das Potential an der Basis des Emitterfolgers 18 ansteigt. Der Transistor 50 beginnt leitend zu werden, wenn das positve Taktsignal am Eingang 22 angelegt wird, und der Emitterfolger 28 beginnt nichtleitend zu werden (Zeitpunkt $T_2$) und erzeugt ein Ausgangssignal 74. Dieses Ausgangssignal sinkt ab, da auch das Basispotential am Emitterfolger 28 absinkt. Die Schaltung nach Fig. 2 arbeitet jedoch so, daß der Emitterfolger 18 noch nicht voll leitend ist während der Emitterfolger 28 sein Ausgangssignal verringert hat. Die Folge davon ist eine kurze Schwankung 76 des Ausgangssignales 64, welche nach dem Zeitpunkt $T_2$ auftritt. Im wesentlichen ist die Amplitude dieser Signalschwankung 76 gleich der Summe der beiden Taktsignale 68 und 72 nach dem Zeitpunkt $T_2$. Nach $T_2$ hat sich die Schaltung stabilisiert und liegt das Potential des Ausgangssignales 64 auf dem « 1 »-Niveau, wobei sowohl das Datensignal 62 als auch das Rückkopplungssignal 66 im « 0 »-Zustand sind.

Zum Zeitpunkt $T_3$ wird das positive Taktpulssignal 72 abgeschaltet. Wenn hiernach zum Zeitpunkt $T_4$ auch das negative Taktsignal 68 abgeschaltet wird, ergibt sich ein Flakkern, d. h. eine kurzzeitige Schwankung 78 des Ausgangssignales 64. Auch hier entsteht dieses Störspannungssignal 78 dadurch, daß der Emitterfolger 28 nur langsam in den leitenden Zustand gebracht wird (Signal 74) und durch den Abfall des Ausgangssignales 70 des Emitterfolgers 18.

Die in Fig. 4 gezeigte Schaltung gestattet es, das beschriebene Signalflackern zu vermeiden. Schaltungselemente in Fig. 4, die auch in Fig. 2 gezeigt sind, sind mit dem gleichen Bezugszeichen bezeichnet. Die Schaltung gemäß Fig. 4 weist gegenüber der in Fig. 2 gezeigten Schaltung den Unterschied auf, daß eine weitere Verbindung 21 vorgesehen ist, welche, wie schon in Fig. 1 gezeigt, die beiden Stromschalter 10 und 12 miteinander verbindet. Die Leitung 21 stellt gemäß Fig. 4 den Verbindungspunkt dar, an dem der gemeinsame Verschiebungswiderstand 46 mit den beiden Kollektorwiderständen 44 und 58 der beiden Transistoren 32 und 50 verbunden ist. Während in der Schaltung nach Fig. 2 die beiden Transistoren 32 und 50 jeweils individuelle Widerstände 46 und 60 aufwiesen, ist also gemäß Fig. 4 ein für beide Stromschalter gemeinsamer Lastwiderstandsteil vorgesehen. Die Verbindung 21 hat die Auswirkung, daß der Emitterfolger 18 rascher eingeschaltet wird, während das Abschalten des Emitterfolgers 28 etwas verzögert wird, wenn das positive und das negative Taktsignal aktiv werden. Durch die Verbindung 21 wird auch der Emitterfolger 28 rasch eingeschaltet, bevor der Emitterfolger 18 abgeschaltet wird, wenn das positive und das negative Taktsignal abgeschaltet werden.

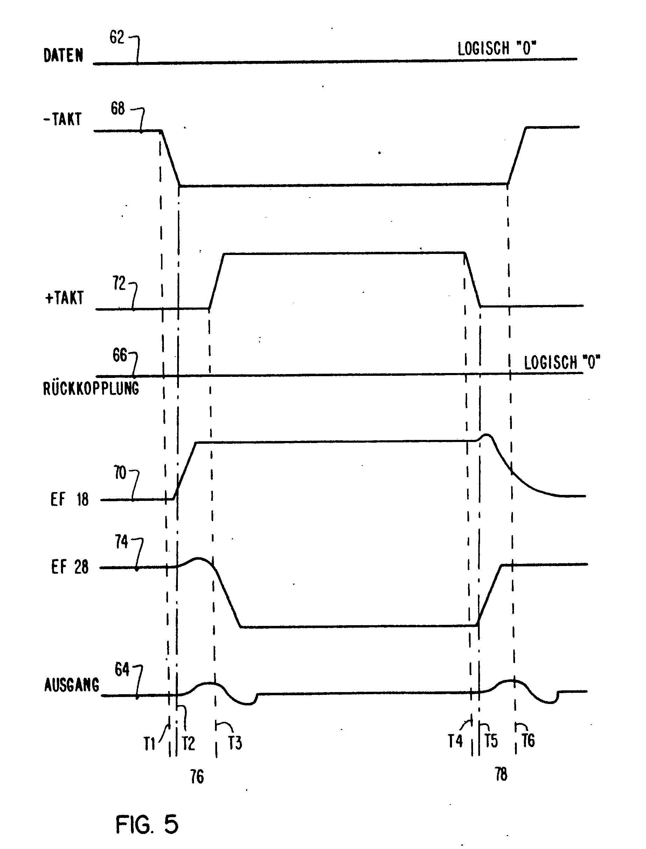

Wie in Fig. 5 gezeigt, ändert sich das Datensignal 62 nicht in der Zeitperiode zwischen den Zeitpunkten $T_1$ und $T_6$. Das negative Taktsignal 68 beginnt zum Zeitpunkt $T_1$ aktiv zu werden und ist zum Zeitpunkt $T_2$ voll negativ, d. h. voll aktiv. Das positive Taktsignal 72 wird geringfügig gegenüber dem negativen Taktsignal verzögert und beginnt somit erst zum Zeitpunkt $T_3$ aktiv zu werden. Zeitlich zusammenfallend damit beginnt auch das Nichtleitendwerden des Emitterfolgers 28 (Signal 74). Während der Periode $T_2$-$T_3$ sind beide Transistoren 32 und 50 abgeschaltet und in dieser Übergangsperiode fließt kein Strom durch den Verschiebungswiderstand 46.

Das Potential an der Basis der Emitterfolgers 18 steigt in Richtung der Speisespannung $V_{cc}$, ausgehend vom niederen Potential zum Zeitpunkt $T_1$, an. Das Ausgangssignal vom Emitterfolger 18 steigt rasch zum hohen Spannungspegel an. Der Emitterfolger 28 hingegen, der vor dem Zeitpunkt $T_1$ leitend war, wird in seinem Abschalten etwas durch das positive Taktsignal 72 verzögert. Das Ausgangssignal 74 des Emitterfolgers 28 erhöht sich geringfügig durch die Erhöhung des Basispotentials und fällt langsamer ab, als das Ausgangssignal am Emitterfolger 18 ansteigt. Das Ausgangssignal 64 zeigt während der Zeit um $T_3$ am Ausgang 30 eine geringfügige Variation, welche zuerst aus einer geringfügigen Erhöhung und dann aus einer geringfügigen Abschwächung des Signales besteht (Signalvariation 76).

Beim folgenden Wechsel der Taktsignale ist die Erhöhung und die Abschwächung des Ausgangssignales 64, die durch das Signal 78 gezeigt ist, zurückzuführen auf die gemeinsame Basisspannung der Emitterfolger 18 und 28 und das rasche Abschalten des Emitterfolgers 28, wenn das positive Taktsignal am Transistor 50 inaktiv wird. Gleichermaßen wird der Emitterfolger 28 bei $T_5$ rasch eingeschaltet, während der Emitterfolger 18 langsamer ausgeschaltet wird. Auch hier zeigt das Ausgangssignal 64 an der Klemme 30 zwischen den Zeitpunkten $T_5$ und $T_6$ eine geringfügige Erhöhung und nach dem Zeitpunkt $T_6$ eine geringfügige Abschwächung des Ausgangssignales 64 (Signalvariation 78), welche auf die gleichen Ursachen zurückzuführen sind, die bereits im Zusammenhang mit der Zeitperiode $T_2$ bis $T_3$ erklärt wurden.

Die Verbindung 21 hat also die Wirkung, daß das Anschalten und Abschalten der Transistoren 18 und 28 intern kompensiert wird und ein im wesentlichen konstantes Ausgangssignal erzeugt wird, wenn der « 0 »-Zustand sowohl für das Datensignal als auch für das Rückkoppelungssignal 66 gegeben ist. Über die Verbindung 20 wird ein Abschalten des Stromes zum Verschiebungswiderstand 46, der als gemeinsamer Kollektorwiderstand für die Transistoren 32 und 50 vorgesehen ist, erreicht. Außerdem wird das Einschalten der Emitterfolger 18 und 28 beschleunigt und das hohe Potentialniveau erreicht, bevor durch das Abschalten der Emitterfolger 28 und 18 das Ausgangspotential der Kippschaltung verringert werden konnte. Die Verbindung 21 gestattet es also, eine gemeinsame steuernde Eingangsspannung für die beiden Emitterfolger 18 und 28 vorzusehen, mit dem Resultat, daß ihr gemeinsames Ausgangssignal weniger von den Vorder- und Rückflanken der steuernden Taktpulssignale beeinflußt werden.

**Ansprüche**

1. Speicherkippschaltung mit einem ersten Stromverteilungsschalter (10) mit einem ersten Multiemittertransistor (32) und einem damit emittergekoppelten ersten weiteren Transistor (34), mit einem zweiten Stromverteilungsschalter (12) mit einem zweiten Multiemittertransistor (50) und einem damit emittergekoppelten zweiten weiteren Transistor (52),
— mit einem ersten Emitterfolger (18), der vom ersten Multiemittertransistor gesteuert wird,
— mit einem zweiten Emitterfolger (28), der vom zweiten Multiemittertransistor gesteuert wird,
— und worin die Emitter der beiden Emitterfolger miteinander und mit einer Ausgangsklemme (30) der Kippschaltung verbunden sind,
dadurch gekennzeichnet, daß eine weitere Verbindung (21) zwischen den beiden Kollektorstromkreisen der beiden Stromverteilungsschalter (10, 12) vorgesehen wird, und daß zumindest ein Teil der Kollektorwiderstände der beiden Multiemittertransistoren (32, 50) als gemeinsamer, von beiden Kollektorströmen dieser Transistoren durchflossener Widerstand (46) ausgeführt wird, so daß die Steuerungseingänge der beiden Emitterfolgertransistoren (18, 28) miteinander gekoppelt werden.

2. Speicherkippschaltung nach Anspruch 1, dadurch gekennzeichnet, daß der erste Multiemittertransistor (32) zwei in Serie geschaltete Kollektorwiderstände (44, 46) aufweist, deren Verbindungspunkt über die zusätzliche Verbindung (21) und über den Kollektorwiderstand (58) des zweiten Multiemittertransistors (50) mit dem Kollektor des zweiten Multiemittertransistors (50) verbunden ist, so daß der speisespannungsseitige Teil (46) der beiden in Serie geschalteten Kollektorwiderstände für beide Multiemittertransistoren gemeinsam ist, und daß die Basiselektrode des ersten Emitterfolgers (18) und die Basiselektrode des zweiten Emitterfolgers (28) jeweils direkt mit den Kollektoren der sie steuernden Multiemittertransistoren (32, bzw. 50) verbunden sind.

3. Speicherkippschaltung nach Anspruch 1, dadurch gekennzeichnet, daß der Kollektor des ersten weiteren Transistors (34) über eine die beiden Stromverteilungsschalter (10, 12) verbindende Leitung (20) und einen dritten Emitterfolger (26) sowie weiter über eine Rückkoppelungsverbindung (24) mit einem Steuereingang des zweiten Multiemittertransistors (50) verbunden ist.

4. Speicherkippschaltung nach Anspruch 1, dadurch gekennzeichnet, daß die Multiemittertransistoren (32, 50) jeweils zwei Basiselektroden (14, 16 bzw. 24, 22) aufweisen, daß an die Basiselektroden des ersten Multiemittertransistors das zu speichernde binäre Datensignal (14) und ein negatives Taktsignal (16) angelegt wird, daß an die beiden Basiselektroden des zweiten Multiemittertransistors (50) das Rückkopplungssignal (66) und ein positives Taktpulssignal (22) angelegt wird, daß die Vorderflanke des positiven Taktpulssignales (72, Fig. 5) gegenüber der Vorderflanke des negativen Taktpulssignales (68) verzögert wird, und daß die Rückflanke des negativen Taktpulssignales (68) gegenüber der Rückflanke des positiven Taktpulssignales (72) verzögert wird.

**Claims**

1. Memory latch with a first current switch (10) with a first multi-emitter transistor (32) and a first further transistor (34) emitter-coupled therewith, with a second current switch (12) with a second multi-emitter transistor (50) and a second further transistor (52) emitter-coupled therewith,
— with a first emitter follower (18) controlled by the first multi-emitter transistor,
— with a second emitter follower (28) controlled by the second multi-emitter transistor,
— and wherein the emitters of the two emitter followers are coupled to each other and to an output terminal (30) of the latch,
characterized in that a further connection (21) between the two collector circuits of the two current switches (10, 12) is provided, and that at least part of the collector resistors of the two multi-emitter transistors (32, 50) consists of a common resistor (46) through which pass the two collector currents of these transistors, so that the control inputs of the two emitter follower transistors (18, 28) are coupled to each other.

2. Memory latch as claimed in claim 1, characterized in that the first multi-emitter transistor (32) comprises two series-arranged collector resistors (44, 46) whose point of connection is connected to the collector of the second multi-emitter transistor (50) via the additional connection (21) and via the collector resistor (58) of the second multi-emitter transistor (50), so that the part (46) on the feeding voltage side of the two series-arranged collector resistors is common to both multi-emitter transistors, and that the base electrode of the first emitter follower (18) and the base electrode of the second emitter follower (28) are respectively directly connected to the collectors of the multi-emitter transistors (32 and 50, respectively) controlling them.

3. Memory latch as claimed in claim 1, characterized in that the collector of the first further transistor (34) is connected via a line (20) connecting the two current switches (10, 12) and a third emitter follower (26), as well as via a feedbach connection (24), to a control input of the second multi-emitter transistor (50).

4. Memory latch as claimed in claim 1, characterized in that the multi-emitter transistors (32, 50) each comprise two base electrodes (14, 16 and 24, 22), that to the base electrodes of the first multi-emitter transistor the binary data signal (14) to be stored and a negative clock signal (16) are applied, that to the two base electrodes of the second multi-emitter transistor (50) the feed-back signal (66) and a positive clock pulse signal (22) are applied, that the leading edge of the positive clock pulse signal (72, Fig. 5) is delayed relative to the leading edge of the negative clock pulse signal (68), and that the trailing edge of the negative clock pulse signal (68) is delayed relative to the trailing edge of the positive clock pulse signal (72).

**Revendications**

1. Bascule bistable de mémoire qui comporte un premier commutateur de courant (10) avec un premier transistor (32) à multi-émetteurs et un autre premier transistor (34) couplé par son émetteur au précédent, ainsi qu'un second commutateur de courant (12) avec un autre second transistor (50) à multi-émetteurs et un second transistor (52) couplé par son émetteur au précédent, laquelle bascule bistable de mémoire comprend :

— un premier émetteur suiveur (18) commandé par ledit premier transistor à multi-émetteurs,

— un deuxième émetteur suiveur (28) commandé par ledit second transistor à multi-émetteurs,

— où les émetteurs des deux émetteurs suiveurs sont reliés, d'une part, entre eux et, d'autre part, à la borne de sortie (30) de la bascule de mémoire,

caractérisée en ce qu'il est prévu une autre connection (21) entre les deux circuits de collecteur des deux dits commutateurs de courants (10, 12), et qu'au moins une partie des résistances de collecteur des deux transistors à multi-émetteurs (32, 50) est réalisée comme une résistance (46) commune à travers laquelle passent les deux courants de collecteurs desdits transistors de telle sorte que les entrées de commande des deux transistors (18, 28) émetteurs suiveurs sont reliées entre elles.

2. Bascule de mémoire selon la revendication 1, caractérisée en ce que le premier transistor (32) à multi-émetteurs comporte deux résistances de collecteur (44, 46) montées en série dont le point de connexion est reliée à travers la connexion auxiliaire (21) et à travers la résistance de collecteur (58) dudit second transistor (50) à multi-émetteurs audit collecteur de ce transistor (50) de telle sorte que les deux résistances de collecteur montées en série des deux transistors à multi-émetteurs ont en commun la partie (46) du côté de l'alimentation en tension et, que l'électrode de base dudit premier émetteur suiveur (18) et l'électrode de base dudit deuxième émetteur suiveur (28) sont respectivement reliées aux collecteurs des transistors (32 ou 50) à multi-émetteurs les commandant.

3. Bascule de mémoire selon la revendication 1, caractérisée en ce que ledit collecteur dudit autre premier transistor (34) est relié à travers une ligne de connexion (20) reliant les deux commutateurs de courant (10, 12), à travers un troisième émetteur suiveur (26), et à travers une connexion de contre-réaction (24) à l'entrée de commande dudit second transistor (50) à multi-émetteurs.

4. Bascule de mémoire selon la revendication 1, caractérisée en ce que les transistors (32, 50) à multi-émetteur comportent chacun deux électrodes de base (14, 16 et 24, 22), que le signal de données (14) sous forme binaire à enregistrer et un signal de synchronisation négatif (16) sont appliqués aux électrodes de base dudit premier transistor à multi-émetteurs et qu'un signal de contre-réaction (66) et un signal d'impulsion de synchronisation positif (22) sont appliqués aux deux électrodes de base dudit second transistor à multi-émetteurs (50), que le flanc montant dudit signal d'impulsion de synchronisation positif (72, voir figure 5) est retardé par rapport au flanc montant du signal d'impulsion de synchronisation négatif (68) et que le flanc descendant du signal d'impulsion de synchronisation négatif (68) est retardé par rapport au flanc descendant du signal d'impulsion de synchronisation positif (72).

**0 025 502**

FIG. 1

FIG. 3

1

0 025 502

FIG. 2

FIG. 4

DATEN  62  LOGISCH "0"

-TAKT  68

+TAKT  72

RÜCKKOPPLUNG  66  LOGISCH "0"

EF 18  70

EF 28  74

AUSGANG  64

T1  T2  T3          T4  T5  T6

76          78

FIG. 5